# FASCICULE DE BREVET EUROPEEN

(11) **EP 1 415 014 B1**
(45) Date de publication et mention de la délivrance du brevet: **04.05.2005**
(21) Numéro de dépôt: 02784870.4
(22) Date de dépôt: 12.07.2002
(51) Int. Cl.: C23C 16/02

(54) **PROCEDE DE FABRICATION DE MATERIAUX COMPOSITES DIAMANTES**
VERFAHREN ZUR HERSTELLUNG VON DIAMANTBESCHICHTETEN VERBUNDWERKSTOFFEN
METHOD FOR MAKING DIAMOND-COATED COMPOSITE MATERIALS

(30) Priorité: 13.07.2001 FR 0109357
(43) Date de publication de la demande: 06.05.2004
(73) Titulaire: CENTRE NATIONAL DE LA RECHERCHE SCIENTIFIQUE (CNRS), 75016 Paris (FR)
(72) Inventeur: MICHAU, Dominique, F-33800 Bordeaux (FR); DEMAZEAU, Gérard, F-33171 Gradignan (FR); LARGETEAU, Alain, F-33610 Cestas (FR); MANAUD, Jean-Pierre, F-33450 Saint Loubes (FR)
(74) Mandataire: Warcoin, Jacques
(86) Numéro de dépôt international: PCT/FR2002/002476
(87) Numéro de publication internationale: WO 2003/006706

(56) Documents cités:
- EP-A- 0 503 822
- EP-A- 0 589 641
- PATENT ABSTRACTS OF JAPAN vol. 018, no. 004 (C-1149), 6 janvier 1994 (1994-01-06) -& JP 05 247652 A (IDEMITSU PETROCHEM CO LTD), 24 septembre 1993 (1993-09-24)
- BERNER A ET AL: "Influence of Cr-N interlayer properties on the initial stages of CVD diamond growth on steel substrates" DIAMOND AND RELATED MATERIALS, ELSEVIER SCIENCE PUBLISHERS, AMSTERDAM, NL, vol. 7, no. 2-5, 1 février 1998 (1998-02-01), pages 597-602, XP004115113 ISSN: 0925-9635

## Description

La présente invention concerne les matériaux composites diamantés.

On connaît depuis longtemps les matériaux composites diamantés comportant un substrat sur lequel est appliquée une couche de diamant ou de carbone diamanté.

Le dépôt de tels revêtements sur le substrat est réalisé le plus souvent en utilisant la technique de Dépôt Chimique en Phase Vapeur (en anglais CVD) permettant d'obtenir des revêtements de plusieurs microns (le terme communément admis CVD sera utilisé par la suite).

Les deux publications de base pour ce qui est de la technique CVD sont :
a) Vapour Growth of Diamond on Diamond and Other Surfaces, B.V. Spitsyn et al., J. of Crystal Growth 52 (1981), 219-26 ;
b) Growth of Diamond Particles from Methane-Hydrogen Gas. S. Matsumoto et al., J. of Materials Science 17 (1982), 3106-12.

Mais, il a été constaté à l'usage que de tels matériaux ainsi revêtus présentaient une fragilité provenant essentiellement des tensions internes du revêtement, de sa mauvaise adhérence au substrat et de la différence de conductivité thermique entre le revêtement (à forte conductivité) et le substrat (à moindre conductivité).

Dans certains cas la composition chimique du substrat facilite la formation de graphite au détriment de celle du diamant.

Pour résoudre ces problèmes, on a proposé l'interposition d'une couche intermédiaire entre le substrat et le revêtement diamanté. Par exemple, dans le cas d'un substrat choisi dans le groupe comprenant un composé métallique dur lié par un métal, le brevet EP 0166708 propose une couche intermédiaire constituée par du titane.

Le brevet US 6 165 616 propose également l'utilisation d'une couche intermédiaire mais en prédéterminant et en contrôlant l'épaisseur et les propriétés de cette couche au fur et à mesure de son dépôt pour réduire la tension du revêtement.

Les informations contenues dans les documents techniques antérieurs précités, en particulier sur les différentes formes de la technique CVD sont incorporées à la présente description à titre de référence.

La présente invention se situe dans le domaine précité des matériaux composites diamantés comportant une couche intermédiaire appliquée sur le substrat et un revêtement diamanté extérieur appliqué sur la couche intermédiaire.

Selon la caractéristique essentielle de l'invention, la couche intermédiaire est choisie de telle manière qu'elle puisse engager des liaisons chimiques avec le substrat, tout en pouvant évoluer chimiquement lors du dépôt de diamant afin de renforcer l'adhérence substrat-/couche intermédiaire et couche intermédiaire/couche de diamant.

Selon une autre caractéristique de l'invention, la couche intermédiaire est soumise à un traitement de surface, et l'ensemble substrat - couche intermédiaire subit un traitement thermique de recuit, le tout avant le dépôt de diamant.

Ainsi, l'invention propose-t-elle un procédé d'élaboration du matériau composite diamanté comportant successivement le dépôt sur le substrat d'une couche intermédiaire évolutive, le traitement de surface de la couche intermédiaire et le recuit de l'ensemble substrat-/couche intermédiaire et le dépôt par les techniques CVD d'un revêtement de diamant polycristallin.

La présente invention concerne ainsi à la fois un matériau composite diamanté et son procédé de fabrication.

Elle concerne également les articles ou pièces comportant un substrat ainsi revêtu. Les domaines d'application sont les plus variés, notamment tribologiques (voir par exemple les revêtements anti-frottement), mécanique (outils de coupe d'usinage et/ou de broyage), optique (surface réfléchissante utilisable dans les transferts optiques), électronique (drains thermiques, semi-conducteurs,...).

La description qui va suivre en se référant notamment aux dessins annexées fera mieux comprendre comment l'invention peut être réalisée, faisant apparaître d'autres caractéristiques et avantages de l'invention..

Le substrat utilisé est constitué par un carbure de tungstène WC allié cobalt, la proportion en poids de cobalt allant de 3 à 20 %.

On sait que le cobalt, même en faibles quantités, peut orienter la formation de carbone de type sp² ce qui conduit à des couches de diamant de mauvaise qualité du fait de l'incorporation de carbone graphitique.

L'invention réside dans la sélection d'une couche intermédiaire évolutive susceptible de servir de barrière de diffusion du cobalt et apte d'une part à engager des liaisons chimiques avec le substrat WC afin d'assurer une bonne adhérence et d'autre part de faciliter la nucléation et la croissance du diamant ainsi que dans deux traitements qui lui sont associés.

Selon une variante de l'invention, premier de ces traitements est un polissage diamant de la surface de cette couche intermédiaire après dépôt sur le substrat WC-Co, le second est un recuit thermique entre 400 et 700°C de l'ensemble substrat plus couche intermédiaire.

En effet, dans le cas d'un substrat du type WC-Co, le dépôt direct d'une couche de diamant sur un tel substrat conduit à des couches très inhomogènes, le cobalt orientant préférentiellement la formation du graphite. C'est pourquoi tout dépôt de diamant doit être précédé soit d'une extraction du cobalt en surface soit d'un masquage, soit d'une mobilisation du cobalt dans une phase très stable.

L'extraction de cobalt conduit à une surface de substrat perturbée et non dense donc relativement inappropriée à faciliter l'adhérence avec la couche de diamant. La mobilisation du cobalt conduit à une hétérogénéité de la couche superficielle du substrat et donc modifie l'adhérence de la couche de diamant.

En revanche, le masquage du cobalt implique la création d'une barrière de diffusion efficace tout en permettant la nucléation et la croissance du diamant. L'invention propose pour ce faire le polissage de la couche intermédiaire.

Le second traitement est un recuit de l'ensemble substrat/couche intermédiaire.

Plus avantageusement les caractéristiques principales de l'invention sont
1. la sélection d'une couche intermédiaire répondant principalement à trois fonctions :
   - être une barrière de diffusion efficace, d'où le choix comme couche intermédiaire d'un matériau renfermant des liaisons fortes,
   - faciliter l'adhérence substrat WC-Co et couche intermédiaire, pour cela il est nécessaire que les liaisons chimiques au sein du matériau choisi comme couche intermédiaire soient compatibles avec celles W-C ,
   - permettre la nucléation du diamant à sa surface et l'adhérence couche de diamant/couche intermédiaire.

   Le diamant étant du carbone, la composition de la couche intermédiaire a été choisie de telle manière qu'elle facilite les liaisons avec le substrat WC et le diamant C. En outre, le procédé CVD de dépôt de diamant impliquant le bombardement de la couche intermédiaire par des espèces carbonées, on a sélectionné une composition de couche intermédiaire susceptible d'évoluer durant la phase de dépôt de diamant.
   Deux compositions ont été choisies :
   - Ti(C,N) constituée en réalité d'une couche de TiC sur une couche de TiN, -Ti₂N

   Après la phase 3 et le dépôt, la composition de ces deux couches est sensiblement voisine : TiC₁₋ₓNₓ.
2. Choix d'un traitement de surface de la couche intermédiaire.
   La sélection de la couche intermédiaire ayant pour objectif principal de jouer le rôle de barrière. de diffusion vis à vis du cobalt, la seconde étape du procédé avait pour objectif de renforcer la densité de nucléation du diamant à la surface de la couche intermédiaire.
   Des essais de dépôt de diamant sur une couche intermédiaire non traitée telle que Ti(C,N) ou Ti₂N (compositions nominale d'origine) conduit à une densité de nucléation faible.
   Il a été trouvé qu'un traitement de polissage de cette couche intermédiaire par des grains très fins de diamant (0,10µm) dispersés dans un feutre conduisait après dépôt CVD de diamant à un très fort accroissement de la densité de nucléation pour des temps de dépôt identiques.
   La seconde étape ayant pour objectif d'activer la nucléation du diamant à la surface de la couche intermédiaire, il a été mis en place une troisième étape destinée à faciliter l'adhérence substrat/couche intermédiaire. Le phénomène d'adhérence étant principalement corrélé à la création de liaisons chimiques, la troisième phase a consisté en un recuit thermique.
3. Recuit thermique de l'ensemble substrat/couche intermédiaire.

Cet ensemble est recuit à une température optimisée de 650°C pour une épaisseur de couche intermédiaire [Ti(C,N) ou Ti₂N] voisine de 3µm et un substrat WC allié avec 6% de Co.

Il a alors été mis en évidence trois caractéristiques importantes :
- la diffusion du titane et du carbone dans WC... formant alors une interface "liante" (W₁₋ₓTiₓC),
- la sauvegarde de l'efficacité du traitement de surface de la couche intermédiaire,
- l'accroissement considérable de la densité de nucléation du diamant.

Il apparaît donc que le procédé en trois étapes successives selon l'invention conduit à des couches de diamant adhérentes et d'excellente qualité à la surface d'un substrat de WC allié cobalt.

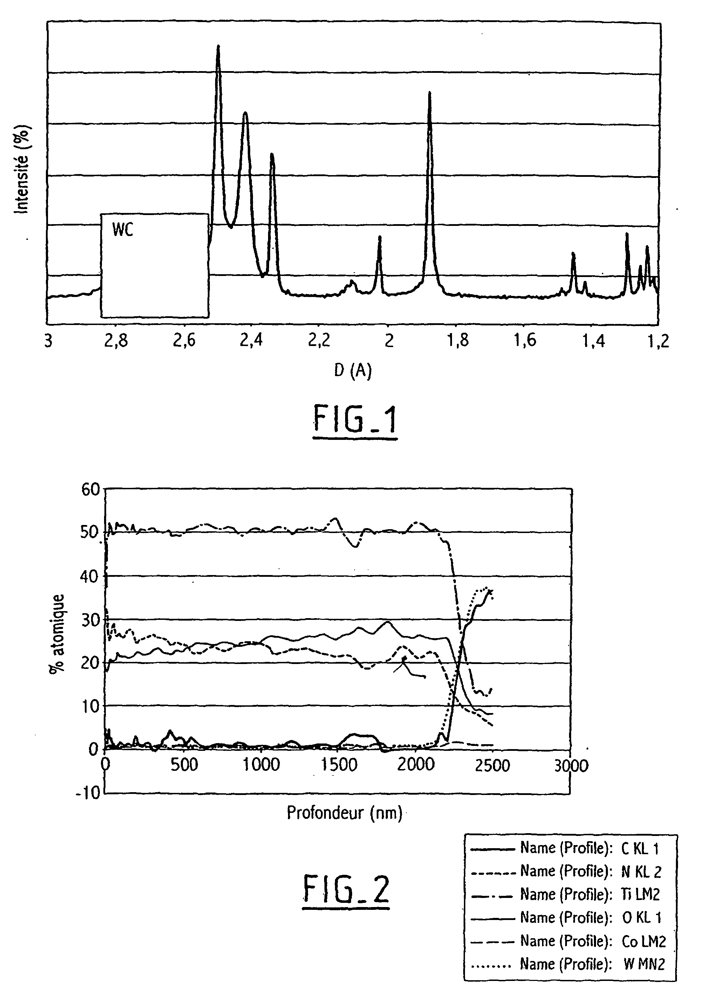

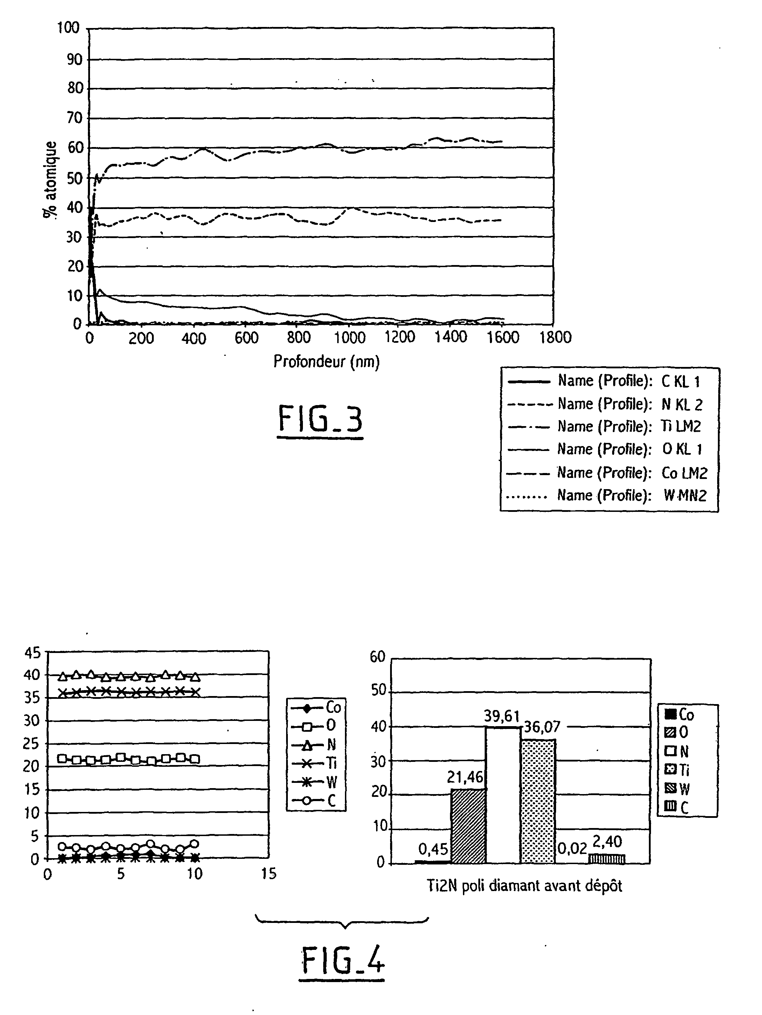

L'invention sera mieux comprise à la lecture des exemples qui vont suivre se référant aux figures 1 à 13 sur lesquelles :
- La figure 1 est un diagramme de diffraction des rayons X du film de Ti₂N déposé sur un substrat de WC-Co à 5 % ;
- La figure 2 est un profil de concentration par spectroscopie Auger du film de Ti₂N déposé sur un substrat de WC-Co à 5 % et contenant environ 25 % d'oxygène ;
- La figure 3 est un profil de concentration par spectroscopie Auger du film de Ti₂N déposé sur un substrat de WC-Co à 5 % et contenant environ 5 % d'oxygène ;
- La figure 4 est une analyse par microsonde de Castaing (microsonde X) du film de Ti₂N déposé sur un substrat de WC-Co ;
- La figure 5 est un diagramme de diffraction des rayons X du film de diamant déposé sur un substrat de WC-allié cobalt (5 %) revêtu de Ti₂N poli diamant à 1/10µm ;
- La figure 6 est un profil de concentration obtenu par spectroscopie Auger du film de Ti₂N déposé sur un substrat de WC-Co à 5 % et contenant environ 25 % d'oxygène ;
- La figure 7 représente des microphotographies du film de diamant déposé ;
- La figure 8 représente le spectre Raman du dépôt de diamant ;
- La figure 9 représente des microphotographies du film de diamant déposé ;
- La figure 10 représente des microphotographies du film de diamant déposé ;
- La figure 11 représente des microphotographies du film de diamant déposé ;
- La figure 12 représente le spectre Raman du dépôt de diamant ;
- La figure 13 représente des microphotographies d'un dépôt de diamant sur un film intermédiaire de Ti₂N non prétraité.

### EXEMPLE 1

Un échantillon de carbure de tungstène allié cobalt avec un pourcentage de cobalt de 5 % et de géométrie cylindrique ou cubique est, dans une première étape, revêtu par un film d'héminitrure de titane soit Ti₂N.

Le dépôt de Ti₂N s'effectue par la technique du dépôt physique en phase vapeur (PVD).

Un barreau de titane, après avoir été fondu par le canon à électron, est pulvérisé dans une enceinte sous pression réduite confinant un plasma d'azote. Le titane réagit alors avec le plasma d'azote et se condense sur la surface du substrat en carbure de tungstène allié cobalt au moyen d'une polarisation.

Le dépôt de Ti₂N par PVD a lieu à une pression de 10⁻³ mbar d'azote pure et une puissance de 100 Watt. La vitesse de croissance du film est maintenue entre 3.5 et 4.5 A/s pour une épaisseur totale comprise entre 1 et 5µm.

Le film de Ti₂N ainsi obtenu a été caractérisé par diffraction des rayons X, par spectroscopie Auger et par microsonde de Castaing (microsonde X).

Dans une seconde étape, le film de Ti₂N déposé sur le substrat de carbure de tungstène allié cobalt est ensuite poli à l'aide d'une suspension diamantée (grains de diamant # 0.1µm).

Dans une troisième étape, le substrat de carbure de tungstène allié cobalt revêtu du film de Ti₂N traité en surface est ensuite introduit dans une enceinte de dépôt chimique en phase vapeur (CVD) assisté par filaments chauds.

Le procédé de dépôt commence par un recuit à 650°C pendant 60 minutes sous un flux d'hydrogène pur à une pression comprise entre 20 et 50 mbar et un débit de 300 sccm (standard cubic centimeters per minute).

Après ce recuit de 60 minutes, les espèces carbonées sont introduites, sous forme de CH₄, dans le flux d'hydrogène (0.7%CH₄).

Dans cette technique, les filaments de tungstène (0.1 mm) sont portés à température par effet Joule par le passage d'un courant intense (20-35V, 10-20A).

Les conditions expérimentales mises en oeuvre sont les suivantes :
- température des filaments (5xW, Ø 0.1 mm) : 2000°C,
- température du substrat : 800-850°C,
- pression : 30 mbar
- débit gazeux : 0.7 % de CH₄, 99.3 % de H₂, débit 300 sccm,
- temps de dépôt : 6 heures

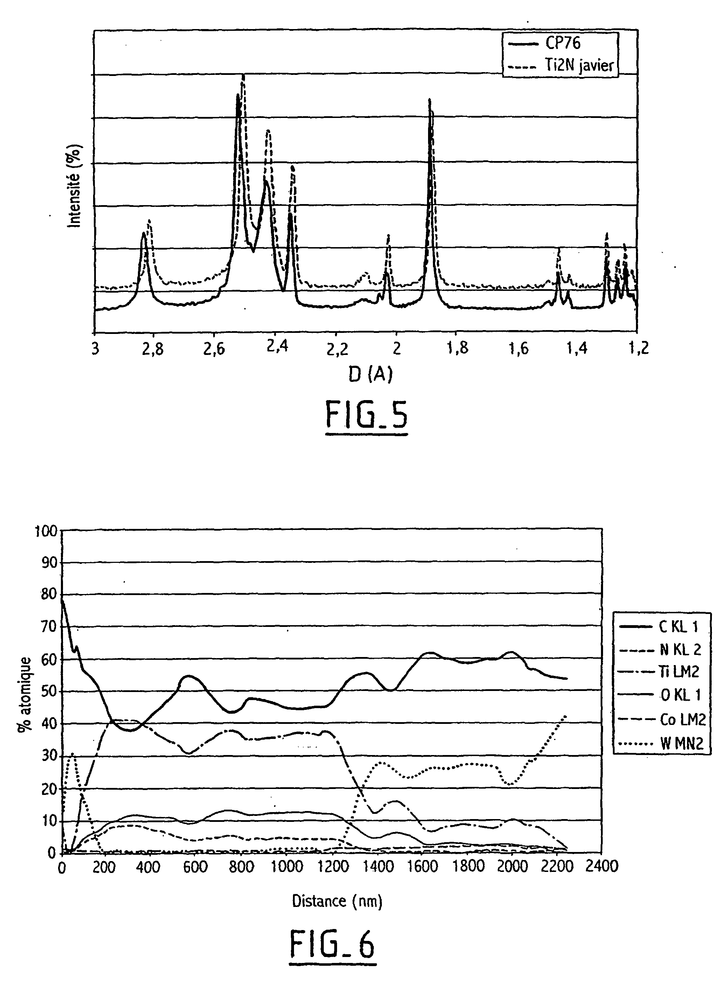

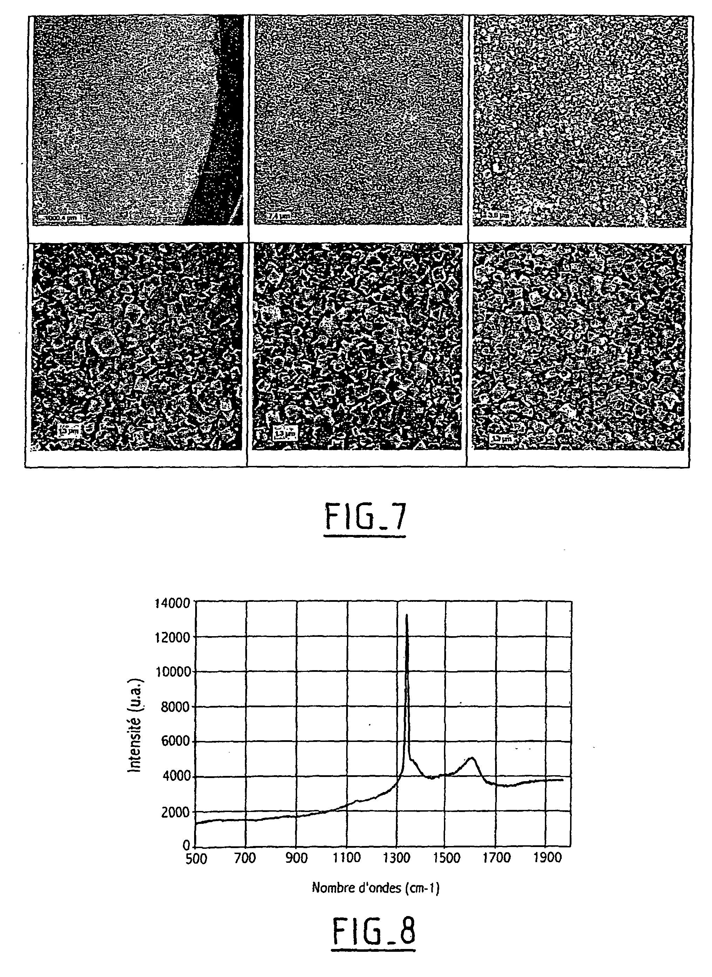

Les substrats de carbure de tungstène allié cobalt revêtu du film d'une couche intermédiaire de Ti₂N poli à 1/10µm et recouvert par un film de diamant ont été caractérisés par :
- diffraction des rayons X (Figure 5),
- spectroscopie Auger (Figure 6),
- microscope électronique à balayage (MEB) (Figure 7),
- spectroscopie Raman (Figure 8),
- microsonde X (microsonde de Castaing).

### EXEMPLE 2 : influence du pourcentage de cobalt.

Un échantillon de carbure de tungstène allié cobalt avec un pourcentage de cobalt de 16 % et de géométrie cylindrique ou cubique est, dans une première étape, revêtu par un film d'héminitrure de titane soit Ti₂N.

Le dépôt de Ti₂N est réalisé dans les mêmes conditions que celles décrites à l'exemple 1.

Le traitement de la surface de Ti₂N est identique à celui décrit dans l'exemple 1.

Le recuit de l'ensemble couche intermédiaire Ti₂N / substrat ainsi traité est réalisé dans les mêmes conditions que celles décrites à l'exemple 1.

Le dépôt de diamant s'effectue dans les mêmes conditions que celles décrites à l'exemple 1.

Les clichés obtenus par microscopie électronique à balayage de la couche de diamant montrent une excellente homogénéité de la taille des grains et une excellente répartition sur le substrat.

Cet exemple montre que le résultat obtenu est très peu sensible au pourcentage de cobalt contenu dans le substrat de WC-allié cobalt. Le film de Ti₂N joue donc bien également un rôle de barrière de diffusion.

### EXEMPLE 3 : influence du recuit de l'ensemble couche intermédiaire / substrat.

Un échantillon de carbure de tungstène allié cobalt avec un pourcentage de cobalt de 5 % et de géométrie cylindrique ou cubique est, dans une première étape, revêtu par un film d'héminitrure de titane soit Ti₂N.

Le dépôt de Ti₂N est réalisé dans les mêmes conditions que celles décrites à l'exemple 1.

Le traitement de la surface de Ti₂N est identique à celui décrit dans l'exemple 1.

Aucun recuit de l'ensemble couche intermédiaire / substrat n'est effectué.

Le dépôt de diamant s'effectue dans les mêmes conditions que celles décrites à l'exemple 1.

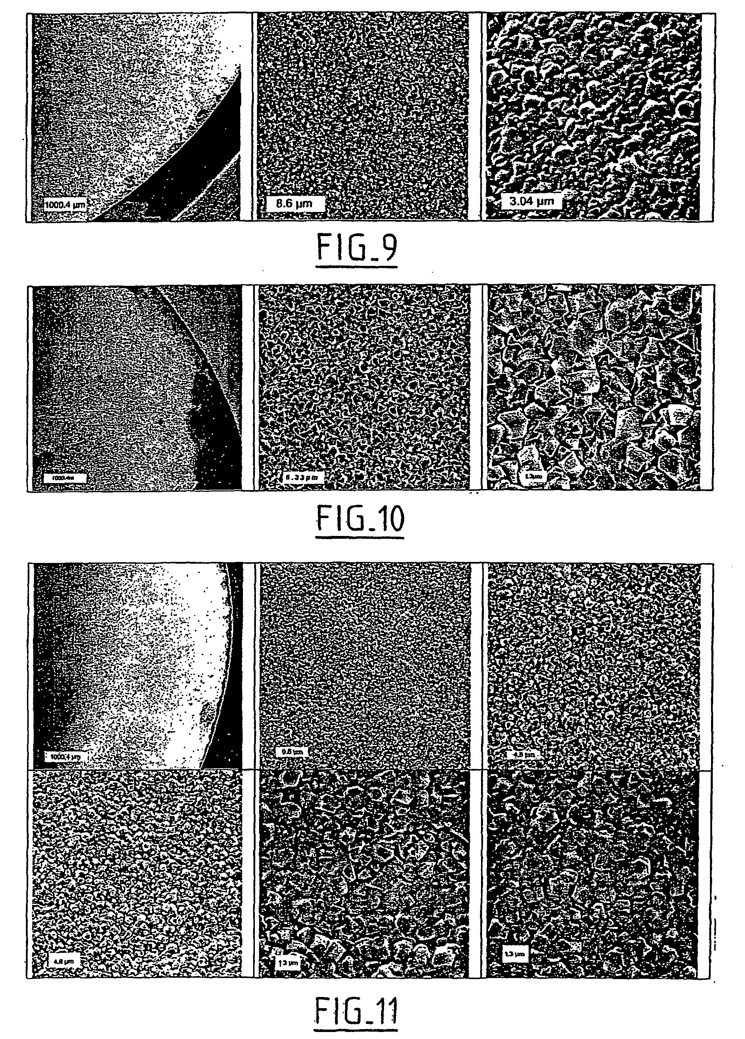

L'absence de recuit dans cet exemple met en évidence une plus grande différence de taille des cristallites de diamant. L'adhérence de la couche de diamant est également plus faible (Figure 10).

### EXEMPLE 4 : influence de la nature du film intermédiaire.

Un échantillon de carbure de tungstène allié cobalt avec un pourcentage de cobalt de 5 % et de géométrie cylindrique ou cubique est, dan une première étape, revêtu par un film de carbonitrure de titane (Ti(C,N)).

Le traitement de la surface de (Ti(C,N) est identique à celui décrit dans l'exemple 1.

Le recuit de l'ensemble couche intermédiaire (Ti(C,N) / substrat ainsi traité est réalisé dans les mêmes conditions que celles décrites à l'exemple 1.

Le dépôt de diamant s'effectue dans les mêmes conditions que celles décrites à l'exemple 1.

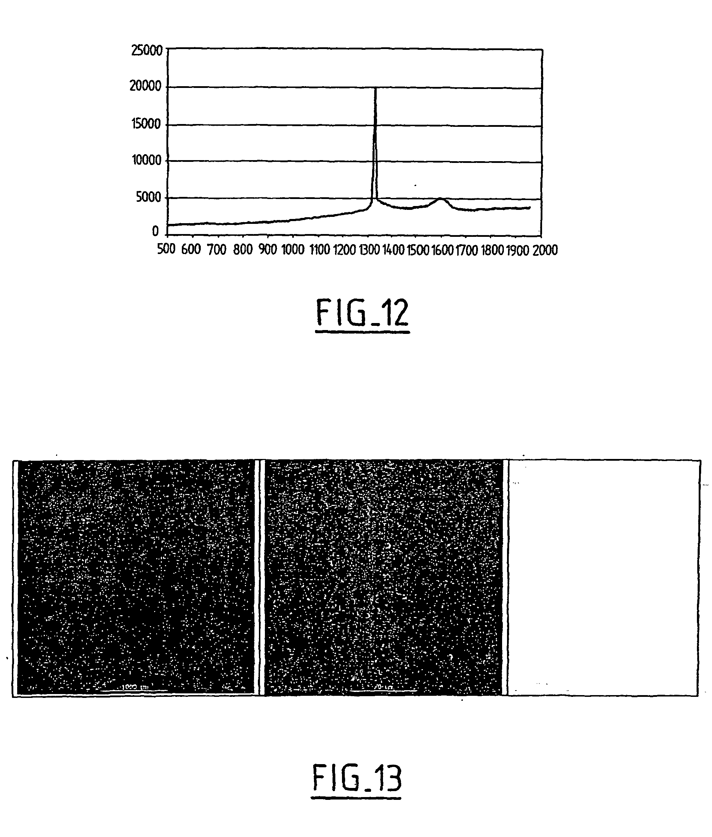

Les clichés obtenus par microscopie électronique à balayage sont donnés à la figure 11. La caractérisation Raman est donnée à la figure 12.

Dans cet exemple, le changement de nature du film intermédiaire n'a pas une grande influence sur la densité de nucléation et sur la taille des grains. le principal changement intervient sur la plus faible adhérence du film de diamant sur le substrat.

### EXEMPLE 5 : influence du prétraitement de l'ensemble couche intermédiaire / substrat.

Un échantillon de carbure de tungstène allié cobalt avec un pourcentage de cobalt de 5 % et de géométrie cylindrique ou cubique est, dans une première étape, revêtu par un film d'héminitrure de titane soit Ti₂N.

Le dépôt de Ti₂N est réalisé dans les mêmes conditions que celles décrites à l'exemple 1.

Aucun traitement de surface n'a été réalisé sur le film de Ti₂N.

Aucun recuit de l'ensemble couche intermédiaire / substrat n'est effectué.

Le dépôt de diamant s'effectue dans les mêmes conditions que celles décrites à l'exemple 1.

Dans cet exemple, où aucun prétraitement de la couche intermédiaire n'a eu lieu, aucune formation de diamant n'est observée (Figure 13).

A l'encontre de toutes les antériorités du Rapport de Recherche Préliminaire, la présente demande de brevet définit un procédé nouveau et inventif résultant de la mise en oeuvre d'une couche évolutive selon un concept original.

## Revendications

1. Procédé de fabrication d'un matériau composite diamanté comportant un substrat constitué par un carbure de tungstène WC allié cobalt, la proportion en poids de cobalt allant de 3 à 20 %, dans lequel on effectue successivement le dépôt sur le substrat d'une couche intermédiaire de Ti₂N ou de carbonitrure de titane susceptible d'engager.les liaisons chimiques avec le substrat et avec un revêtement diamanté, un traitement de surface de la couche intermédiaire, un recuit de l'ensemble substrat / couche intermédiaire, et le dépôt par les techniques CVD du revêtement diamanté.

2. Procédé selon la revendication 1, **caractérisé en ce que** le traitement de surface de la couche intermédiaire est un traitement de polissage.

3. Les matériaux composites diamantés obtenus par le procédé selon l'une des revendications 1 et 2.

4. Les articles ou pièces en un matériau composite diamanté selon la revendication 3

## Patentansprüche

1. Verfahren zur Herstellung eines Diamanten umfassenden Verbundwerkstoffs, umfassend ein Substrat, welches aus einem mit Kobalt legierten Wolframcarbid WC, wobei der Gewichtsanteil von Kobalt 3 bis 20% beträgt, besteht, bei welchem man nacheinander das Abscheiden einer Zwischenlage aus Ti₂N oder aus Titancarbonitrid, welche in der Lage ist, chemische Bindungen mit dem Substrat und mit einem Diamanten umfassenden Überzug einzugehen, auf dem Substrat, eine Oberflächenbehandlung der Zwischenlage, ein Tempern der Gesamtheit aus Substrat/Zwischenlage und das Abscheiden des Diamanten umfassenden Überzugs durch CVD-Techniken ausführt.

2. Verfahren nach Anspruch 1, **dadurch gekennzeichnet, dass** die Oberflächenbehandlung der Zwischenlage eine Polierbehandlung ist.

3. Diamanten umfassende Verbundwerkstoffe, welche durch das Verfahren nach einem der Ansprüche 1 und 2 erhalten werden.

4. Gegenstände oder Teile aus einem Diamanten umfassenden Verbundwerkstoff nach Anspruch 3.

## Claims

1. Process for manufacturing a diamond-coated composite comprising a substrate consisting of a cobalt-alloyed tungsten carbide WC, the proportion of cobalt by weight ranging from 3 to 20%, in which process the following are carried out in succession: deposition on the substrate of an interlayer of Ti₂N or titanium carbonitride capable of forming chemical bonds with the substrate and with a diamond coating, surface treatment of the interlayer, annealing of the substrate/interlayer assembly and deposition of the diamond coating by CVD techniques.

2. Method according to Claim 1, **characterized in that** the surface treatment of the interlayer is a polishing treatment.

3. Diamond-coated composites obtained by the process according to either of Claims 1 and 2.

4. Articles or parts made of a diamond-coated composite according to Claim 3.
